(19) Europäisches Patentamt
European Patent Office
Office européen des brevets

(11) **EP 3 489 292 B1**

(12) **EUROPEAN PATENT SPECIFICATION**

(45) Date of publication and mention of the grant of the patent:
**08.12.2021 Bulletin 2021/49**

(21) Application number: **17833757.2**

(22) Date of filing: **06.04.2017**

(51) Int Cl.:
*C08J 9/34* (2006.01)      *H01Q 1/38* (2006.01)
*H01L 23/14* (2006.01)

(86) International application number:
**PCT/JP2017/014375**

(87) International publication number:
**WO 2018/020746 (01.02.2018 Gazette 2018/05)**

(54) **LOW-DIELECTRIC POROUS POLYMER FILM AND FILM FOR MILLIMETER-WAVE ANTENNA**

NIEDRIGDIELEKTRISCHE PORÖSE POLYMERFOLIE UND FOLIE FÜR MILLIMETERWELLENANTENNE

FILM POLYMÈRE POREUX À FAIBLE CONSTANTE DIÉLECTRIQUE ET FILM POUR ANTENNE À ONDES MILLIMÉTRIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.07.2016   JP 2016145541**

(43) Date of publication of application:
**29.05.2019   Bulletin 2019/22**

(73) Proprietor: **Nitto Denko Corporation
Ibaraki-shi, Osaka 567-8680 (JP)**

(72) Inventors:
- **NAKAMURA, Masayoshi**
  **Ibaraki-shi**
  **Osaka 567-8680 (JP)**
- **HODONO, Masayuki**
  **Ibaraki-shi**
  **Osaka 567-8680 (JP)**
- **ITO, Takahiko**
  **Ibaraki-shi**
  **Osaka 567-8680 (JP)**
- **NAGAOKA, Naoki**
  **Ibaraki-shi**
  **Osaka 567-8680 (JP)**
- **HISHIKI, Tomoaki**
  **Ibaraki-shi**
  **Osaka 567-8680 (JP)**

(74) Representative: **Gill Jennings & Every LLP
The Broadgate Tower
20 Primrose Street
London EC2A 2ES (GB)**

(56) References cited:
EP-A1- 0 052 936        WO-A1-02/078824
WO-A1-2010/038873       JP-A- 2001 151 929
JP-A- 2003 201 362      JP-A- 2003 201 363
JP-A- 2004 155 933      JP-A- 2006 111 708
JP-A- 2014 231 533

**Description**

TECHNICAL FIELD

The present invention relates to a low-dielectric porous polymer film. In particular, the present invention relates to a low-dielectric porous polymer film useful as a sheet for a millimeter-wave antenna.

BACKGROUND ART

A millimeter wave is an electromagnetic wave having a frequency of 30 GHz to 300 GHz, which is called like that because the wavelength thereof is in a millimeter order (1 mm to 10 mm). From a viewpoint that an electromagnetic wave having a frequency lower than the millimeter wave, such as a microwave, is generally not much influenced by rain it has been utilized in broadcasting by television, radio, mobile phone communications, and long-range wireless communications. In contrast, the millimeter wave has difficulty in being used in long-range wireless communications, because it undergoes attenuation due to rain, and attenuation due to resonance absorption caused by oxygen or water molecules in the air.

On the other hand, because of a shorter wavelength, the millimeter wave is capable of transmitting a larger amount of data at one time. Further, in a case where the millimeter wave is applied to imaging techniques, resolution is enhanced, so that it is expected to obtain an image having a higher definition than that obtainable by microwave imaging. Therefore, the millimeter wave is expected to be used for short-range wireless communications and for a radar to be mounted to a vehicle such as an automobile.

An antenna for use in a millimeter-wave communication module (millimeter-wave antenna) typically has a structure in which an array of antenna electrodes formed of wires is provided on a resin or ceramic substrate. A power loss of an antenna is proportional to wiring loss and antenna radiation loss, wherein the wiring loss is proportional to the square root of the dielectric constant of the substrate, and the antenna radiation loss is proportional to the dielectric constant of the substrate, respectively. Therefore, in order to enhance the gain of the millimeter-wave antenna to increase a millimeter-wave communication range as long as possible, it is effective to lower the dielectric constant of the substrate.

The dielectric constant of a plastic material such as a resin is generally determined by a molecular structure. Thus, as an approach to lower the dielectric constant, it is conceivable to modify the molecular structure. However, even in polyethylene and polytetrafluoroethylene having relatively low dielectric constants, the dielectric constants are, respectively, about 2.3 and about 2.1, so that there are limits to lower the dielectric constant of a plastic material by means of control of the molecular structure thereof. Moreover, the modification of the molecular structure is likely to lead to a problem that physical properties, such as strength and linear expansion coefficient, of a film formed using the plastic material undesirably changes.

A polyimide resin is widely used as a material for components or elements requiring reliability, e.g., electronic or electric components and devices such as a circuit board, from a viewpoint of its characteristics such as high insulation, dimensional stability, formability and lightweight. Particularly, in recent years, along with improvements in performance and functionality of electric or electronic devices, the electric or electronic devices are required to achieve faster transmission of information, and elements for use in these devices are also required to comply with such higher-speed transmission. With regard to polyimide to be used for such devices or elements, it is attempted to lower the dielectric constant and the dielectric loss tangent thereof so as to provide electric properties complying with the higher-speed transmission.

As another approach to lower the dielectric constant, there have been proposed various methods intended to porosify a plastic material to control the dielectric constant in accordance with the porosity of the resulting porous plastic material, based on the fact that the dielectric constant of air is 1.

For example, JP H09-100363A discloses a heat-resistant, low-dielectric, plastic insulating film usable in a printed-wiring board of an electronic device and for slot insulation in a rotary machine, wherein the film comprises porous plastic having a porosity of 10 vol% or more, and has a heat resistant temperature of 100°C or more and a dielectric constant of 2.5 or less.

Further, JP 2012-101438A discloses a laminate of a metal foil layer and a polyimide layer including a porous polyimide layer, which is useful as a board for a printed-wiring board, wherein the polyimide layer comprises a non-porous polyimide layer, a porous polyimide layer and a non-porous polyimide layer which are laminated on one surface of the metal foil layer in this order, and wherein a total thickness of the polyimide layers is from 10 to 500 $\mu$m, and the thickness of the porous polyimide layer falls within the range of 10% to 90% with respect to the total thickness of the polyimide layers.

JP 2003-201362A discloses a further low dielectric porous polyimide film which can be used in a board for millimeter-wave antenna.

Examples of a conventional method for obtaining a porous polymer include a dry method and a wet method.

As the dry method, there have been known a physical foaming method and a chemical foaming method.

The physical foaming method comprises: dispersing, as a foaming agent, a low-boiling-point solvent such as chlorofluorocarbon or hydrocarbon, in a polymer to prepare a mixture; and then heating the mixture to volatilize the foaming agent to thereby obtain a porous body.

On the other hand, the chemical forming method comprises: adding a foaming agent to a polymer to prepare a mixture; and thermally decomposing the mixture to form cells by means of gas generated through the thermal decomposition to thereby obtain a foamed body.

Foaming based on the physical approach involves various environmental problems such as hazardous properties of a substance used as the foaming agent and destruction of the ozone layer. Moreover, generally, the physical approach is suitably used to obtain a foamed body having a cell diameter of several ten $\mu$m or more, but has a difficulty in obtaining a foamed body having cells with fine and uniform diameters.

On the other hand, in foaming based on the chemical approach, after completion of the foaming, a residue of the foaming agent generating the gas is highly likely to be left inside the foamed body. Thus, particularly in use for electronic components highly requiring a low contamination property, contamination by a corrosive gas or impurities is likely to become a problem.

Further, as a method for obtaining a porous body having a small cell diameter and a high cell density, there has been proposed a method comprising: dissolving an inert gas such as nitrogen gas or carbon dioxide gas, in a polymer at a high pressure; and then, after releasing the pressure, heating the polymer up to around a glass-transition temperature or a softening temperature thereof to thereby form cells. This foaming method is designed to form nuclei from a thermodynamically instable state, and allow the formed nuclei to expand and grow to thereby form cells, so that it has an advantage of being able to obtain a previously-unattainable microporous foamed body.

For example, JP 2001-081225A discloses a process for a porous body usable as, e.g., a circuit board of an electronic device, wherein the porous body has fine cells and exhibits a low dielectric constant and a heat-resisting property. The process comprises removing, from a polymer composition having a microphase-separated structure in which non-continuous phases having an average diameter of less than 10 $\mu$m are dispersed over a continuous phase of a polymer, a component constituting the non-continuous phase, by at least one operation selected from vaporization and decomposition, and an extraction operation, to thereby porosify the polymer composition, wherein liquefied carbon dioxide or carbon dioxide being in a supercritical state is used as an extraction solvent for the component constituting the non-continuous phase

Further, JP 2002-146085A discloses a process for a porous polyimide usable as a circuit board of an electronic device, wherein the porous polyimide has a fine cell structure and exhibits a heat-resisting property. The process comprises: removing, from a polymer composition having a microphase-separated structure in which non-continuous phases composed of a dispersible compound B and having an average diameter of less than 10 $\mu$m are dispersed over a continuous phase composed of a polyimide precursor A, the dispersible compound B; and then converting the polyimide precursor A into a polyimide to thereby produce the porous polyimide, wherein an interaction parameter $\chi_{AB}$ between the polyimide precursor A and the dispersible compound B satisfies the following relationship: $3 < \chi_{AB}$, and wherein supercritical carbon dioxide is used as an extraction solvent for the dispersible compound B.

CITATION LIST

[Parent Document]

Patent Document 1: JP H09-100363A
Patent Document 2: JP 2012-101438A
Patent Document 3: JP 2001-081225A
Patent Document 4: JP 2002-146085A
Patent Document 5 : JP 2003-201362A

SUMMARY OF INVENTION

[Technical Problem]

It is an object of the present invention to provide a low-dielectric porous polymer film having a low dielectric constant at high millimeter-wave frequencies and thereby useful as a sheet for a millimeter-wave antenna.

[Solution to Technical Problem]

As a result of diligent researches for solving the above problems, the inventers found that the above problems can be solved by a low-dielectric porous polymer film comprising a base material layer made of a polymer material and formed with fine pores dispersed therein to have a substantially smooth skin layer made of the same polymer material of the base material layer and formed on a surface of the base material layer, and have finally reached the present invention.

Specifically, the present invention provides a low-dielectric porous polymer film which comprises: a base material layer made of a polymer material and formed with fine pores dispersed therein; and a substantially smooth skin layer made of the same polymer material as that of the base material layer and formed on at least one of the surfaces of the base material layer, as defined in present claim 1.

In the film according to the present invention, the skin layer has a thickness which is preferably less than 10%, more preferably equal to or less than 5%, of a total thickness of the film.

Further, the skin layer has a thickness of 1 to 5 $\mu$m.

In the film according to the present invention, the skin layer may be formed on both of the surfaces of the base material layer.

Further, the skin layer may be liquid-impermeable.

The film according to the present invention has a porosity which is 60% or more, preferably 95% or less.

In the film according to the present invention, the pores of the base material layer have an average pore diameter of 10 $\mu$m or less.

In the film according to the present invention, the pores have a pore diameter distribution with a full width at half maximum which is preferably 10 $\mu$m or less, more preferably 5 $\mu$m or less.

In the film according to the present invention, a porous structure of the film may be an independent-cell structure or may be an interconnected-cell structure, in view of a dielectric property. However, from a viewpoint of processability of a circuit board, an independent-cell structure is preferable.

This is because, for example, in a process of producing an antenna circuit board, when a workpiece is subjected to boring using a drill or laser, and then to plating, there can arise a problem that a plating solution penetrates into a pore from a part thereof exposed to the outside by the boring, resulting in elution of Cu (plating solution penetration), or in a process of laminating a low-dielectric material to a board, hot pressing can give rise to a problem of collapse of pores (anti-press properties).

Here, the term "independent-cell structure" as a type of porous structure of the film may include not only a structure having only a plurality of independent pores (each of which is not in communication with adjacent ones of the remaining pores) but also a structure additionally having an interconnected pore (composed of some adjacent pores communicating with each other) to the extent that does not impair the advantageous effects of the present invention. For example, the independent-cell structure may be formed as a porous structure in which the independent pores account for 80% or more of the entire pores.

Whether the porous structure of the film according to the present invention is the independent-cell structure can be checked using a liquid penetrant to be used in, e.g., the Penetration Test defined in JIS (JIS Z 2343-1).

In this case, it is preferable to use a liquid penetrant having a contact angle with respect to a polymer surface of 25° or less, and a viscosity of 2.4 mm$^2$/s (37.8°C). Specifically, the porous polymer film is cut approximately perpendicularly with respect to a surface thereof so as to form a porous cross-section (cut surface) exposed to the outside, and, after immersing this cross-section in a penetrant such as a red penetrant for 5 minutes, a liquid penetration length (a distance by which the liquid penetrant penetrates into the porous polymer film from the cross-section) is measured. When this liquid penetration length is 500 $\mu$m or less, preferably 300 $\mu$m or less, the porous structure of the film according to the present invention can be considered to be the independent-cell structure.

As one example, for forming the porous structure of the film according the present invention as the independent-cell structure, it is desirable to use polyoxyethylene dimethyl ether as a porosifying agent (or pore-forming agent) for use in production of the film, and, as needed, a nucleus agent such as a polytetrafluoroethylene (PTFE) powder.

The film according to the present invention has a dielectric constant as measured at 60 GHz which is 2.0 or less, preferably 1.4 or less.

Preferably, in the film according to the present invention, the polymer or a precursor of the polymer is soluble in an organic solvent such as N-methylpyrrolidone (NMP).

Preferably, in the film according to the present invention, the polymer is selected from the group consisting of polyimide, polyetherimide, fluorinated polyimide, and polycarbonate.

Preferably, the film according to the present invention has a thickness of 50 $\mu$m to 500 $\mu$m.

The film according to the present invention may be used in a board for a millimeter-wave antenna.

[Effect of Invention]

According to the present invention, it is possible to obtain a low-dielectric porous polymer film having a low dielectric constant at high millimeter-wave frequencies, and use this film in a substrate of a millimeter-wave antenna, thereby enhancing the gain of the millimeter-wave antenna to increase a millimeter-wave communication range.

BRIEF DESCRIPTION OF DRAWINGS

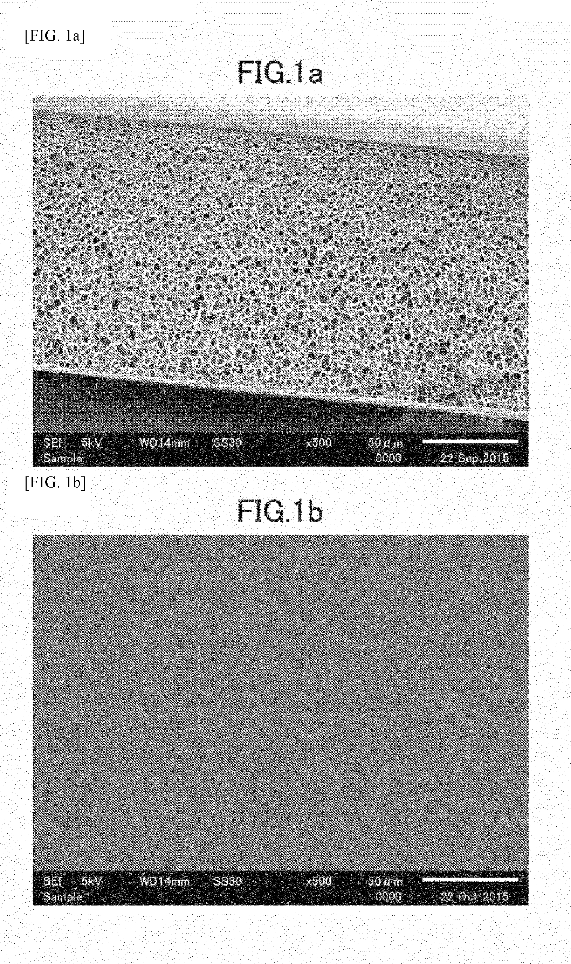

FIG. 1a is an SEM photograph of a cross-section of a film obtained in Inventive Example 1.
FIG. 1b is an SEM photograph of a surface of the film obtained in Inventive Example 1.

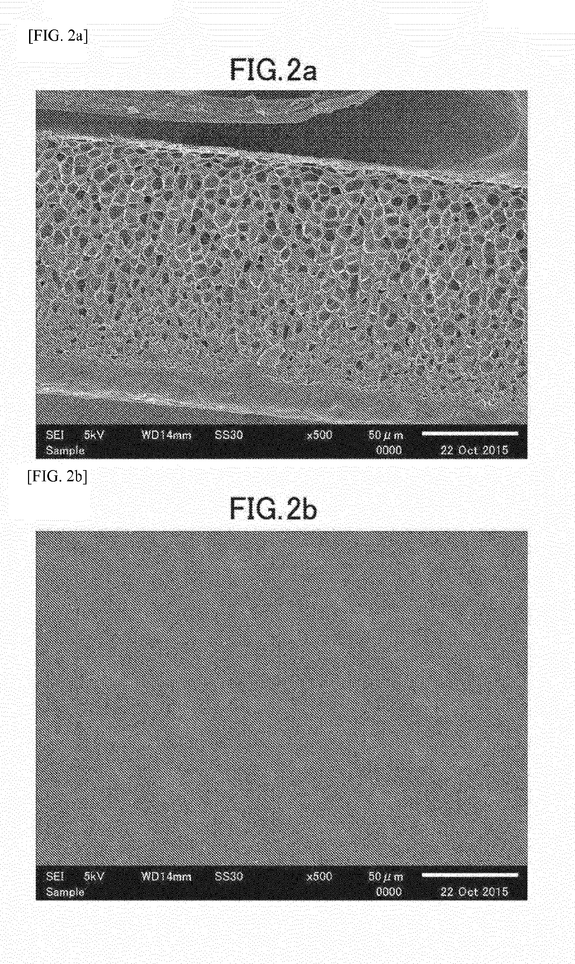

FIG. 2a is an SEM photograph of a cross-section of a film obtained in Inventive Example 2.
FIG. 2b is an SEM photograph of a surface of the film obtained in Inventive Example 2.

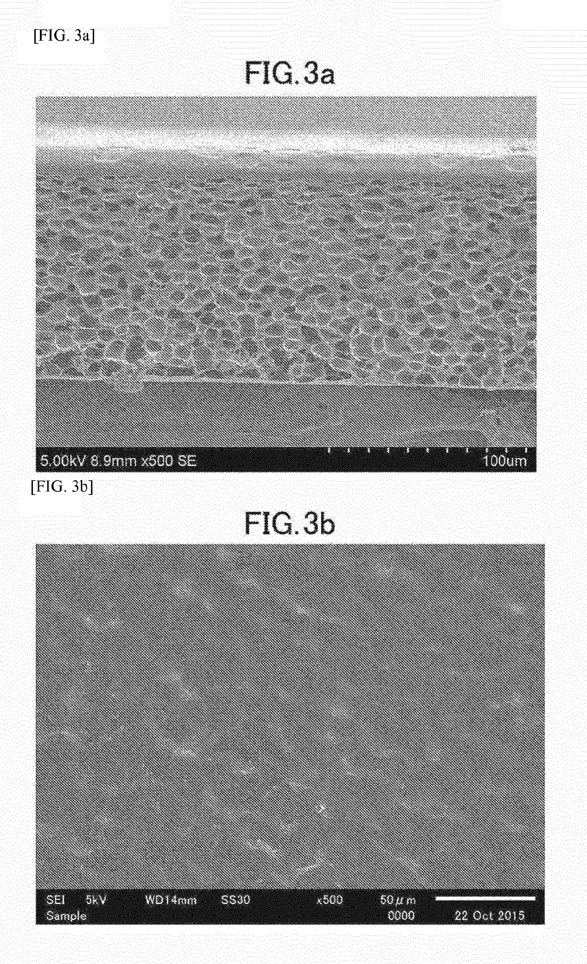

FIG. 3a is an SEM photograph of a cross-section of a film obtained in Inventive Example 3.
FIG. 3b is an SEM photograph of a surface of the film obtained in Inventive Example 3.

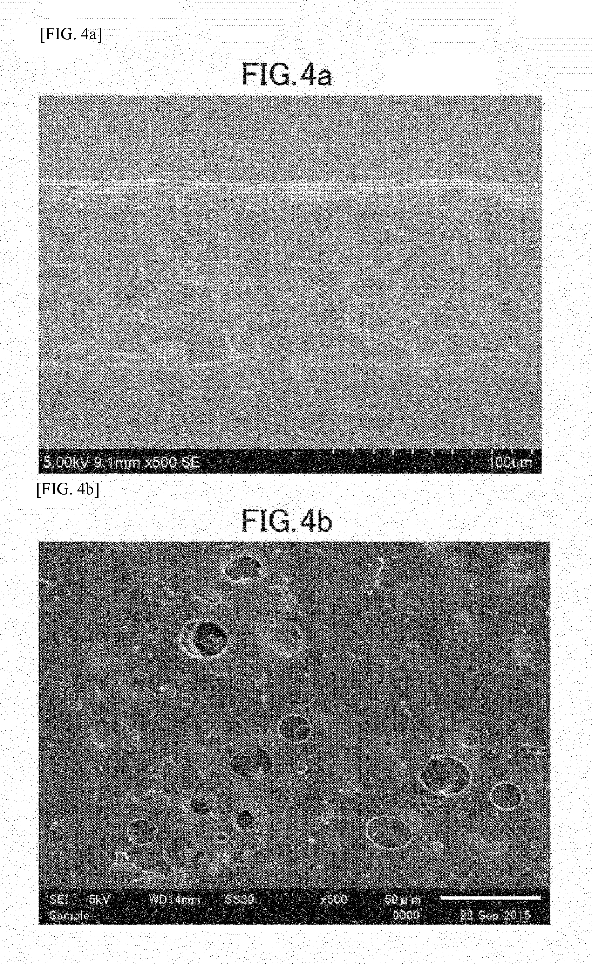

FIG. 4a is an SEM photograph of a cross-section of a film obtained in Comparative Example.
FIG. 4b is an SEM photograph of a surface of a film obtained in Comparative Example.
FIG. 5 is an SEM photograph of a cross-section of a film obtained in Inventive Example 4.
FIG. 6 is an SEM photograph of a cross-section of a film obtained in Inventive Example 5.

DESCRIPTION OF EMBODIMENTS

The film according to the present invention comprises a base material layer made of a polymer material in which fine pores are dispersed, and a substantially smooth skin layer made of the same polymer material as that of the base material layer and formed on the surface of the base material layer.

In the film according to the present invention, the skin layer is formed on one or both of the surfaces of the base material layer, and made of the same polymer material as that of the base material layer. The state of the film according to the present invention in which the base material layer has fine pores dispersedly formed therein, whereas the skin layer is devoid of such pores and is substantially smooth, can be checked, for example, by microscope observation.

In the film according to the present invention, from a viewpoint of avoiding a rise in dielectric constant of the entire film, the thickness of the skin layer is preferably less than 10%, more preferably equal to or less than 5%, of the total thickness of the film. Further, from a viewpoint of forming a smooth skin layer while keeping the dielectric constant of the entire film low, the thickness of the skin layer is in the range of 1 to 5 $\mu$m. The thickness of the skin layer can be measured by scanning electron microscope (SEM) observation.

Further, from a viewpoint of easiness of plating in a process of forming a wiring pattern thereon, the skin layer is preferably liquid-impermeable.

In order to obtain a high antenna gain, it is desirable for the film according to the present invention to have a lowered dielectric constant. From this view point, the porosity of the film is 60% or more. Further, the porosity of the film is preferably 95% or less. The porosity of the film can be obtained by calculation based on the specific gravity of a film without pores and the specific gravity of the film with pores, each measured by an electronic specific gravity meter.

From a viewpoint that an excessive enlargement of the pores leads to significant deterioration in mechanical strength during bending of the porous polymer film, the film according to the present invention is formed such that the pores have an average pore diameter of 10 $\mu$m or less. Further, in the film according to the present invention, the skin layer is useful in forming antenna wires on the surface of the porous polymer film. In this case, if there are irregularities on a surface of the skin layer, irregularities will be undesirably formed in the wires formed thereon. For this reason, the skin layer needs to be smooth. On the other hand, as the skin layer is increased in thickness, the dielectric constant of the entire film undesirably rises. Thus, the skin layer needs to be thin. In the film according to the present invention, the average pore diameter of the pores is set to 10 $\mu$m or less. This makes it possible to easily realize formation of a thin and smooth skin layer as a surface layer of the porous polymer film.

Further, from viewpoints of further improving the mechanical strength during bending of the porous polymer film, and further improving the smoothness of the skin layer, the pores preferably have a pore diameter distribution with a full width at half maximum of 10 $\mu$m or less. The average pore diameter of the pores and the full width at half maximum in the pore diameter distribution of the pores can be measured by image analysis of an SEM photograph of a cross-section of the film.

For example, the film can be obtained by forming a polymer composition having a microphase-separated structure through the following drying-induced phase separation method, and then using a supercritical extraction method. Specifically, a porosifying agent is added to a solution of a polyimide precursor using an organic solvent (NMP) at a given mixing ratio, and the resulting solution is formed in a desired shape (e.g., a sheet, a film), for example, by applying it onto a substrate such as a PET film, a copper foil. Then, the solvent is removed from the resulting shaped body by drying, and the porosifying agent is insolubilized within the polyimide precursor to obtain a polymer composition having a microphase structure in which non-continuous phases comprised of the porosifying agent are dispersed over a continuous phase of the polyimide precursor. Further, the porosifying agent is extracted using supercritical carbon dioxide and then the polyimide precursor is converted to polyimide (imidized). In the above process, the drying is performed at a relatively low temperature for a relatively short time period to intentionally allow part of the organic solvent such as NMP to remain, and, in this state, the porosifying agent is extracted using supercritical carbon dioxide, whereby a film having a desired porosity and a desired average pore diameter can be obtained.

The polyimide precursor usable for obtaining the film according to the present invention may be any intermediate capable of being converted to polyimide, and can be obtained by a known or commonly-used method. For example, the polyimide precursor can be obtained from a reaction between an organic tetracarboxylic dianhydride and a diamino compound (diamine).

Examples of the organic tetracarboxylic dianhydride include pyromelletic dianhydride, 3,3',4,4'-biphenyltetracarboxylic dianhydride, 2,2-bis(2,3-dicarboxyphenyl)-1,1,1,3,3,3-hexafluoropropane dianhydride, 2,2-bis(3,4-dicarboxyphenyl)-1,1,1,3,3,3-hexafluoropropane dianhydride, 3,3'4,4'-benzophenonetetracarboxylic dianhydride, bis(3,4-dicarboxyphenyl)-ether dianhydride, and bis(3,4-dicarboxyphenyl)-sulfonic dianhydride. These organic tetracarboxylic dianhydrides may be used independently or in the form of a mixture of two or more of them.

Examples of the diamino compound include m-phenylenediamine, p-phenylenediamine, 3,4'-diaminodiphenyl ether, 4,4'-diaminodiphenyl ether, 4,4'-diaminodiphenyl sulfone, 3,3'-diaminodiphenyl sulfone, 2,2-bis(4-aminophenoxyphenyl) propane, 2,2-bis(4-aminophenoxyphenyl) hexafluoropropane, 1,3-bis(4-aminophenoxy) benzene, 1,4-bis(4-aminophenoxy)benzene, 2,4-diaminotoluene, 2,6-diaminotoluene, diaminodiphenylmethane, 4,4'-diamino-2,2-dimethylbiphenyl, and 2,2-bis(trifluoromethyl)-4,4'-diaminobiphenyl. These diamino compounds may be used independently or in the form of a mixture of two or more of them.

The polyimide precursor can be obtained by causing a reaction between the organic tetracarboxylic dianhydride and the diamino compound (diamine), typically in an organic solvent at 0 to 90°C for 1 to 24 hours. Examples of the organic solvent include polar solvents such as N-methyl-2-pyrrolidone, N,N-dimethylacetamide, N,N-dimethylformamide, and dimethylsulfoxide. Among them, from the viewpoint that a film having a relatively high porosity and a relatively small average pore diameter can be obtained by intentionally creating the state in which part of the organic solvent remains in the film, and, in this state, extracting the porosifying agent, it is preferable to use N-methyl-2-pyrrolidone whose remaining amount can be easily controlled through control of a drying condition, in a production process of the film, as described later,

The porosifying agent usable for obtaining the film according the present invention may be a component comprising the non-continuous phases in the microphase-separated structure (corresponding to pores in the porous polymer film) and capable of dispersing in the polyimide precursor upon being mixed with the polyimide precursor, more specifically a compound capable of being separated with respect to the polyimide precursor, in the form of fine particle-shaped microphases, so as to form a sea-island structure. More preferably, the porosifying agent is a component removable from the polyimide precursor by an extractive removal operation using supercritical carbon dioxide.

More specifically, examples of the porosifying agent include: polyalkylene glycol such as polyethylene glycol or polypropylene glycol; a compound in which either or both of the terminals of the polyalkylene glycols is blocked by methyl or (meth)acrylate; a compound in which one of the terminals of polyalkylene glycol such as phenoxypolyethylene glycol (meth)acrylate is blocked by an alkyl or aryl group, and the other terminal is blocked by (meth)acrylate; urethane prepolymer; polyhydric alcohol poly(meth)acrylates such as trimethylolpropane tri(meth)acrylate and dipentaerythritol hexa(meth)acrylate; and a (meth)acrylate-based compound such as ε-caprolactone (meth)acrylate, urethane (meth)acrylates, epoxy (meth)acrylates, and oligoester (meth)acrylates. These porosifying agent may be used by selecting one of them or simultaneously selecting two or more of them.

In the film according to the present invention, when a porous structure of the film is formed as an independent-cell structure, it is preferable to use, as the porosifying agent, polyoxyethylene dimethyl ether. Further, in this case, it is preferable to use a nucleus agent such as a polytetrafluoroethylene (PTFE) powder, if necessary.

In a process of obtaining the film according to the present invention, first of all, the porosifying agent is added to a solution of the polyimide precursor using the organic solvent at a given mixing ratio, and, after forming the resulting solution into a sheet, a film or the like, the solvent is removed from the sheet by drying, as mentioned above.

The temperature of the drying for removing the solvent may be set in the range of 60 to 180°C, preferably in the range of 60 to 120°C, although it varies depending on a type of solvent used. Further, the time period of the drying is preferably set in the range of 5 to 60 minutes, more preferably in the range of about 5 to 30 minutes.

Without being bound by any particular theory, a film having a high porosity and a small average pore diameter which could not be obtained by conventional techniques can be obtained by performing the drying at a lower temperature for a shorter time period than those in the conventional techniques to thereby intentionally create the state in which part

6

of the organic solvent such as NMP remains in the film, and, in this state, extracting the porosifying agent using supercritical carbon dioxide.

A remaining amount of the solvent is preferably set in the range of 15 to 250 parts by weight, particularly in the range of 25 to 250 parts by weight, more preferably in the range of 50 to 150 parts by weight, with respect to the amount of the polyimide precursor.

From a viewpoint of setting the average pore diameter to a sufficiently small range, the porosifying agent is preferably added in an amount of 200 parts by weight or less with respect to 100 parts by weight of the polyimide precursor. Further, from a viewpoint of setting the dielectric constant of the film to a sufficiently small value, the porosifying agent is preferably added in an amount of 10 parts by weight or more with respect to 100 parts by weight of the polyimide precursor.

Then, a porous structure is formed by removing the porosifying agent from a polymer composition having a microphase-separated structure composed of the polyimide precursor and the porosifying agent. A method for removing the porosifying agent is not particularly limited, and the removal may be performed by any method like vaporization or decomposition, a removal method using an extraction operation is preferred. The removal using the extraction operation may involve decomposition or transformation of the porosifying agent, or may be performed after decomposition or transformation.

The solvent used for the extractive removal of the porosifying agent is not particularly limited, as long as it is capable of solving the porosifying agent. Carbon dioxide, particularly supercritical carbon dioxide, is preferred from a viewpoint of its removal performance and harmlessness. In a method for removing the porosifying agent from the polyimide composition by using supercritical carbon dioxide, a temperature for performing the method is equal to or greater than the critical point of supercritical carbon dioxide. The temperature is preferably set in a range where imidization of the polyimide precursor is not extremely progressed in the course of the removal. In addition, as the temperature goes higher, solubility of the porosifying agent to the supercritical carbon dioxide becomes lower. Therefore, a temperature during removal of the porosifying agent using supercritical carbon dioxide (extraction temperature) is preferably set in the range of 32 to 230°C, more preferably in the range of 40 to 200°C.

The pressure of the supercritical carbon dioxide during the removal (extraction pressure) is equal to or greater than the critical point of supercritical carbon dioxide. The extraction pressure is preferably set in the range of 7.3 to 100 MPa, more preferably in the range of 10 to 50 MPa.

The supercritical carbon dioxide may be pressurized and then continuously supplied to a pressure-resistant container containing the polymer composition having the microphase-separated structure by using a metering pump, or the supercritical carbon dioxide pre-pressurized at a given pressure may be injected into the pressure-resistant container. The time period of the extraction is set in the range of about 1 to 10 hours, and can be varied depending on the extraction temperature, the extraction pressure, and the amount of the porosifying agent added to the polyimide precursor.

The porosified polyimide precursor from which the porosifying agent has been removed in the above manner is subsequently converted to a porous polyimide through, e.g., dehydration ring-closure reaction. The dehydration ring-closure reaction of the polyimide precursor is performed by heating to the temperature of about 300 to 400°C, or by utilizing a cyclodehydrating agent such as a mixture of acetic anhydride and pyridine.

The film according to the present invention which can be produced by the above method has a dielectric constant as measured at 60 GHz of 2.0 or less, from a viewpoint of lowering of dielectric constant. The dielectric constant of the film can be measured by an open resonator method.

Although the process has been described above in detail based on an example in which the polymer is polyimide, the polymer is preferably selected from the group consisting of polyimide, polyetherimide, fluorinated polyimide, and polycarbonate, from a viewpoint that a drying-induced phase separation method and a supercritical extraction method can be applied to the film according to the present invention.

The film according to the present invention preferably has a thickness of 50 $\mu$m to 500 $\mu$m, from a viewpoint that the film is formed through the coating and drying process.

The film according to the present invention is suitably usable as a film for use in a board for a millimeter-wave antenna.

EXAMPLES

Although the present invention will be specifically described below based on examples, it should be understood that the present invention is not limited to these examples.

(Evaluation of Thickness of Skin Layer, Average Pore Diameter and Pore Diameter Distribution)

The thickness of the skin layer, the average pore diameter and the pore diameter distribution were evaluated by observing a porous configuration using an scanning electron microscope (JSM-6510LV manufactured by JEOL Ltd.).

A sample was cut by a razor to expose a cross-section (cut surface). Further, the cross-section was subjected to platinum evaporation deposition, and then observed. The average pore diameter and the pore diameter distribution (full-width at half-maximum) were calculated by SEM image analysis. In the image analysis, an SEM image was subjected to binarization to identify pores, and then pore diameters were calculated to form a histogram. As for software for the analysis, ImageJ was used. The maximum pore diameter best representing an actual structure was used as a value of the pore diameter in the evaluation of the pore diameter.

(Evaluation of Porosity)

The specific gravity was measured using an electronic specific gravity meter (MD-3005 manufactured by Alfa Mirage). Further, the porosity was calculated using the following formula.

$$\text{Porosity (\%)} = (1 - \text{specific gravity of porous polyimide body/ specific gravity of non-porous polyimide body}) \times 100$$

(Evaluation of Electric Properties)

The dielectric constant (relative permittivity) and the dielectric loss tangent at 10 GHz were measured using a PNA network analyzer (Agilent Technologies Inc.) and a split post dielectric resonator (SPDR). Further, the dielectric constant and the dielectric loss tangent at 60 GHz were measured using a vector network analyzer and an open resonator.

(Evaluation of Mechanical Strength by Bending)

The mechanical strength by bending was evaluated by bending a porous polyimide film by an angle of 90° and observing whether or not breaking occurs during the bending.

(Evaluation of Plating Property)

The obtained film was subjected to sputtering and electrolytic plating to form a 12 $\mu$m-thick Cu foil layer, and, after undergoing an actual wiring pattern-forming process (subtractive process), subjected to a confirmation test for checking whether or not a plating solution intrudes into the film. Subsequently, the cross-section of the film was analyzed using an X-ray microanalyzer (XMA) to check the presence or absence of detection of an element originating from the plating (such as Cu or S). In case of no detection, the film was evaluated as having processability.

(Evaluation of Liquid Penetration)

A porous polyimide body was cut by a razor to expose a resulting cross-section. The cross-section was immersed in a red penetrant (NRC-ALII manufactured by Taiyo Bussan Co. Ltd.) for 5 minutes, and the penetrant adhering to the cross-section was cleaned off. The porous polyimide body was further cut perpendicularly to the exposed cross-section to evaluate the liquid penetration length by an optical microscope.

(Evaluation of Collapse)

A porous polyimide body was cut into a size of 50 mm $\times$ 50 mm, and a resulting sample was pressed by hot-press at 180°C and 3 MPa for 60 munities. Respective thicknesses of the sample before and after the press were measured, and, based on the measured values, a reduction in thickness of the sample after the press was calculated as change rate.

(Migration Test)

A plurality of through-holes each having a bore diameter of 0.3 mm were made in a porous polyimide body at a pitch of 1.52 mm, and a positive electrode and a negative electrode are formed in each of the through-holes. Then, a voltage of 60 V was applied between the positive and negative electrodes at 85°C and 85%RH to measure an insulation resistance value.

Reference Example

(Synthesis of Polyimide Precursor [BPDA/PDA, DPE])

43.2 g of p-phenylenediamine (PDA) and 20g of diaminodiphenyl ether (DPE) were put into a 1000-ml flask equipped with a stirrer and a thermometer, and 768.8 g of N-methyl-2-pyrolidone (NMP) was added thereto and dissolved therein by stirring. Subsequently, 147g of biphenyltetracarboxylic acid dianhydride (BPDA) was gradually added to the above solution, and the resulting solution was stirred at 40°C for 2 hours to promote reaction. Further, the mixture was stirred at 75°C for 12 hours to perform aging. As a result, a polyimide precursor solution having a solid content concentration of 20 wt% was obtained. This polyimide precursor has the following composition in terms of substance amount ratio: PDA : DPE : BPDA = 0.8 mol : 0.2 mol : 1 mol.

Inventive Example 1

To 100 parts by weight of the polyimide precursor solution obtained in Reference Example, 200 parts by weight of polypropylene glycol having a weight-average molecular weight of 400 (grade: D400, manufactured by NOF Corporation) and 400 parts by weight of dimethylacetamide were added. Then, the resulting solution was stirred to obtain a transparent homogeneous solution. Subsequently, 4.2 parts by weight of 2-methylimidazole serving as an imidizing catalyst and 5.4 parts by weight of benzoic anhydride serving as a chemical imidizing agent were added to the above obtained solution to form a mixed solution. This mixed solution was applied onto a PET film or a copper foil by a die process, and dried by hot air at 85°C for 15 minutes to produce a 100 $\mu$m-thick polyimide precursor film having a phase-separated structure.
This film was immersed in carbon dioxide circulated at 40°C while being pressurized to 30 MPa, for 8 hours, to promote extractive removal of the polypropylene glycol, phase separation of residual NMP, and pore formation. Subsequently, the carbon dioxide was depressurized to obtain a porous polyimide precursor film.
Further, the obtained porous polyimide precursor film was subjected to heat treatment under vacuum at 380°C for 2 hours to promote removal of remaining components and imidization to thereby obtain a porous polyimide film.

Inventive Example 2

To 100 parts by weight of the polyimide precursor solution obtained in Reference Example, 200 parts by weight of polypropylene glycol having a weight-average molecular weight of 400 (grade: D400, manufactured by NOF Corporation) and 400 parts by weight of dimethylacetamide were added. Then, the resulting solution was stirred to obtain a transparent homogeneous solution. Subsequently, 4.2 parts by weight of 2-methylimidazole serving as an imidizing catalyst and 1.1 parts by weight of benzoic anhydride serving as a chemical imidizing agent were added to the above obtained solution to form a mixed solution. This mixed solution was applied onto a PET film or a copper foil by a die process, and dried by hot air at 85°C for 15 minutes to produce a 100 $\mu$m-thick polyimide precursor film having a phase-separated structure.
This film was immersed in carbon dioxide circulated at 40°C while being pressurized to 30 MPa, for 8 hours, to promote extractive removal of the polypropylene glycol, phase separation of residual NMP, and pore formation. Subsequently, the carbon dioxide was depressurized to obtain a porous polyimide precursor film.
Further, the obtained porous polyimide precursor film was subjected to heat treatment under vacuum at 380°C for 2 hours to promote removal of remaining components and imidization to thereby obtain a porous polyimide film.

Inventive Example 3

To 100 parts by weight of the polyimide precursor solution obtained in Reference Example, 200 parts by weight of polypropylene glycol having a weight-average molecular weight of 400 (grade: D400, manufactured by NOF Corporation) and 400 parts by weight of dimethylacetamide were added. Then, the resulting solution was stirred to obtain a transparent homogeneous solution. This solution was applied onto a PET film or a copper foil by a die process, and dried by hot air at 85°C for 15 minutes to produce a 100 $\mu$m-thick polyimide precursor film having a phase-separated structure.
This film was immersed in carbon dioxide circulated at 40°C while being pressurized to 30 MPa, for 8 hours, to extractively remove the polypropylene glycol. Subsequently, the carbon dioxide was depressurized to obtain a porous polyimide precursor film.
Further, the obtained porous polyimide precursor film was subjected to heat treatment under vacuum at 380°C for 2 hours to promote removal of remaining components and imidization to thereby obtain a porous polyimide film.

Inventive Example 4

To 100 parts by weight of the polyimide precursor solution obtained in Reference Example, 200 parts by weight of polyoxyethylene dimethyl ether having a weight-average molecular weight of 400 (grade: MM400, manufactured by NOF Corporation) and 150 parts by weight of NMP were added. Then, the resulting solution was stirred to obtain a transparent homogeneous solution. Subsequently, 4.2 parts by weight of 2-methylimidazole serving as an imidizing catalyst was added to the above obtained solution to form a mixed solution. This mixed solution was applied onto a PET film or a copper foil by a die process, and dried by hot air at 120°C for 30 minutes to produce a 100 μm-thick polyimide precursor film having a phase-separated structure.

This film was immersed in carbon dioxide circulated at 40°C while being pressurized to 30 MPa, for 8 hours, to promote extractive removal of the polyoxyethylene dimethyl ether, phase separation of residual NMP, and pore formation. Subsequently, the carbon dioxide was depressurized to obtain a porous polyimide precursor film.

Further, the obtained porous polyimide precursor film was subjected to heat treatment under vacuum at 380°C for 2 hours to promote removal of remaining components and imidization to thereby obtain a porous polyimide film.

Inventive Example 5

To 100 parts by weight of the polyimide precursor solution obtained in Reference Example, 200 parts by weight of polyoxyethylene dimethyl ether having a weight-average molecular weight of 400 (grade: MM400, manufactured by NOF Corporation), 10 parts by weight of PTFE powder having a particle size of about 2 μm and 150 parts by weight of NMP were added. Then, the resulting solution was stirred to obtain a transparent homogeneous solution. Subsequently, 4.2 parts by weight of 2-methylimidazole serving as an imidizing catalyst was added to the above obtained solution to form a mixed solution. This mixed solution was applied onto a PET film or a copper foil by a die process, and dried by hot air at 120°C for 30 minutes to produce a 100 μm-thick polyimide precursor film having a phase-separated structure.

This film was immersed in carbon dioxide circulated at 40°C while being pressurized to 30 MPa, for 8 hours, to promote extractive removal of the polyoxyethylene dimethyl ether, phase separation of residual NMP, and pore formation. Subsequently, the carbon dioxide was depressurized to obtain a porous polyimide precursor film.

Further, the obtained porous polyimide precursor film was subjected to heat treatment under vacuum at 380°C for 2 hours to promote removal of remaining components and imidization to thereby obtain a porous polyimide film.

Comparative Example

To 100 parts by weight of the polyimide precursor solution obtained in Reference Example, 300 parts by weight of polypropylene glycol having a weight-average molecular weight of 400 (grade: D400, manufactured by NOF Corporation) and 400 parts by weight of dimethylacetamide were added. Then, the resulting solution was stirred to obtain a transparent homogeneous solution. This solution was applied onto a PET film or a copper foil by a die process, and dried by hot air at 140°C for 20 minutes to produce a 100 μm-thick polyimide precursor film having a phase-separated structure.

This film was immersed in carbon dioxide circulated at 40°C while being pressurized to 30 MPa, for 8 hours, to extractively remove the polypropylene glycol. Subsequently, the carbon dioxide was depressurized to obtain a porous polyimide precursor film.

Further, the obtained porous polyimide precursor film was subjected to heat treatment under vacuum at 380°C for 2 hours to promote removal of remaining components and imidization to thereby obtain a porous polyimide film.

Results obtained by observing the cross-sections and the surfaces of the films obtained in Inventive Examples 1 to 3 and Comparative Example by SEM are shown in FIGS, 1a and 1b (Inventive Example 1), FIGS, 2a and 2b (Inventive Example 2), FIGS, 3a and 3b (Inventive Example 3) and FIGS, 4a and 4b (Comparative Example), wherein FIG. Xa presents an SEM image of the cross-section, and FIG. Xb presents an SEM image of the surface, where X denotes an integer number of 1 to 4.

These figures show that each of the films obtained in Inventive Examples 1 to 3 has a surface layer formed as a smooth skin layer and a cross-section with no pore, whereas the film obtained in Comparative Example is devoid of such a skin layer, wherein there are pores in its cross-section uniformly, and the presence of irregularities is observed in its surface.

From the results of the SEM observation, the skin layer formed in each of the films obtained in Inventive Examples 1 to 3 has a thickness shown in Table 1.

[TABLE 1]

|  | Thickness of Skin Layer ($\mu$m) | Total thickness of Film ($\mu$m) | Rate of Thickness of Skin Layer (%) |
|---|---|---|---|
| Inventive Example 1 | 2.2 | 130 | 1.7 |
| Inventive Example 2 | 3.6 | 121 | 3.0 |
| Inventive Example 3 | 3.7 | 108 | 3.4 |

Further, results of measurements performed for films obtained in Inventive Examples 1 to 3 and Comparative Example are shown in Table 2.

[TABLES 2]

|  | Porosity (%) | Average Pore Diameter ($\mu$m) | Full Width at Half Maximum ($\mu$m) | Dielectric Constant 10GHz | Dielectric Loss Tangent 10GHz | Dielectric Constant 60GHz | Dielectric Loss Tangent 60GHz | Bending Strength | Processability |
|---|---|---|---|---|---|---|---|---|---|
| Inventive Example 1 | 91 | 4.4 | 4 | 1.22 | 0.0017 | 1.20 | 0.0027 | Good | Good |
| Inventive Example 2 | 84 | 7.5 | 6 | 1.40 | 0.0024 | 1.33 | 0.0046 | Good | Good |
| Inventive Example 3 | 63 | 9.6 | 8 | 1.93 | 0.0063 | 1.80 | 0.014 | Good | Good |
| Comparative Example | 76 | 19.3 | Unevaluable | 1.54 | 0.0029 | 1.42 | 0.0056 | Not Good | Not Good |

As is apparent from the above results, the film according to the present invention exhibits a relatively low dielectric constant and a relatively low dielectric loss tangent, i.e., has excellent electric properties, at high frequencies.

Further, the films obtained in Inventive Examples 1 to 3 and Comparative Example were evaluated in regard to the plating property. As a result, the film obtained in Comparative Example has a problem of liquid penetration, whereas the films obtained in Inventive Examples 1 to 3 could be adequately plated without such a problem.

The films according to the present invention are also excellent in terms of a mechanical or physical property during bending.

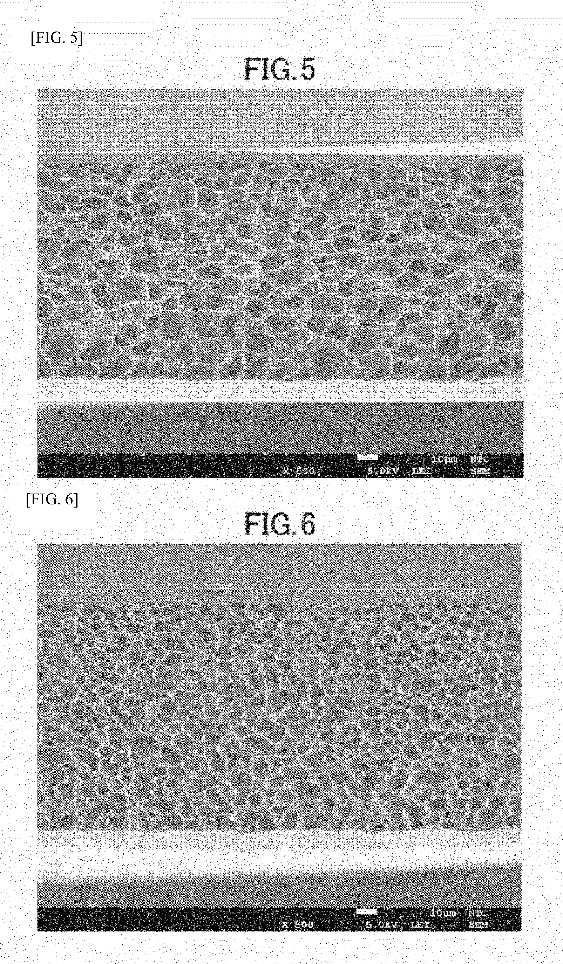

Next, results obtained by observing the cross-sections of the films obtained in Inventive Examples 4 and 5 by SEM are shown in FIG 5 (Inventive Example 4) and FIG.6 (Inventive Example 5).

From the results of the SEM observation, the skin layer formed in each of the films obtained in Inventive Examples 4 and 5 has a thickness shown in Table 3.

[TABLE 3]

|  | Thickness of Skin Layer ($\mu$m) | Total thickness of Film ($\mu$m) | Rate of Thickness of Skin Layer (%) |
|---|---|---|---|
| Inventive Example 4 | 4.8 | 120 | 4.0 |
| Inventive Example 5 | 6.0 | 120 | 5.0 |

Further, results of measurements performed for films obtained in Inventive Examples 4 and 5 are shown in Table 4.

[TABLE 4]

|  | Porosity (%) | Average Pore Diameter ($\mu$m) | Full Width at Half Maximum ($\mu$m) | Dielectric Constant 10GHz | Dielectric Loss Tangent 10GHz | Liquid Penetration | Evaluation of Collapse | Migration |
|---|---|---|---|---|---|---|---|---|
| Inventive Example 4 | 80 | 9.8 | 10 | 1.49 | 0.0040 | 200 $\mu$m | 6% | 5.88E + 10 ($\Omega$) |
| Inventive ExamDle 5 | 81 | 6.5 | 8 | 1.48 | 0.0040 | 20 $\mu$m | 4% | 6.93E + 10 ($\Omega$) |

As is apparent from the above results, the film according to the present invention whose porous structure is an independent-cell structure is excellent in terms of liquid penetration and pressing resistance, as well as excellent electric properties, and exhibits a high insulation resistance value even after processing, so that it is excellent in terms of processability of a circuit board.

**Claims**

1. A low-dielectric porous polymer film comprising:

   a base material layer made of a polymer material and formed with fine pores dispersed therein; and
   a substantially smooth skin layer made of the same polymer material as that of the base material layer but having no pores and formed on at least one of the surfaces of the base material layer;
   wherein the skin layer has a thickness of 1 to 5 $\mu$m;
   wherein the base material layer has a porosity of 60% or more;
   wherein the pores of the base material layer have an average pore diameter of 10 $\mu$m or less; and
   wherein the film has a dielectric constant as measured at 60 GHz of 2.0 or less, all the parameters defined above being determined according to the methods disclosed in the experimental section of this specification.

2. The film as recited in claim 1, wherein the skin layer has a thickness which is less than 10% of a total thickness of the film.

3. The film as recited in claim 2, wherein the thickness of the skin layer is equal to or less than 5% of the total thickness of the film.

4. The film as recited in any one of claims 1 to 3, wherein the skin layer is formed on both of the surfaces of the base material layer.

5. The film as recited in any one of claims 1 to 4, wherein the skin layer is liquid-impermeable.

6. The film as recited in any one of claims 1 to 5, wherein the base material layer has a porosity, determined according to the method disclosed in the experimental section, of 95% or less.

7. The film as recited in any one of claims 1 to 6, wherein the pores in the base material layer have a pore diameter distribution with a full width at half maximum, determined according to the method disclosed in the experimental section, of 10 $\mu$m or less.

8. The film as recited in any one of claims 1 to 7, wherein the polymer or a precursor of the polymer is soluble in an organic solvent, preferably the organic solvent is N-methylpyrrolidone.

9. The film as recited in any one of claims 1 to 8, wherein the polymer is selected from the group consisting of polyimide, polyetherimide, fluorinated polyimide, and polycarbonate.

10. The film as recited in any one of claims 1 to 9, which has a thickness, determined according to the method disclosed in the experimental section, of 50 $\mu$m to 500 $\mu$m.

11. The film as recited in any one of claims 1 to 10, which has a porous structure formed as an independent-cell structure.

12. A board for a millimeter-wave antenna comprising the film as recited in any one of claims 1 to 11.

**Patentansprüche**

1. Niedrig-dielektrischer poröser Polymerfilm, umfassend:

   eine Basismaterialschicht, die aus einem Polymermaterial hergestellt ist und mit darin dispergierten feinen Poren ausgebildet ist; und
   eine im Wesentlichen glatte Hautschicht, die aus demselben Polymermaterial wie das der Basismaterialschicht hergestellt ist, jedoch keine Poren aufweist und auf wenigstens einer der Oberflächen der Basismaterialschicht ausgebildet ist;
wobei die Hautschicht eine Dicke von 1 bis 5 $\mu$m aufweist;
wobei die Basismaterialschicht eine Porosität von 60 % oder mehr aufweist;
wobei die Poren der Basismaterialschicht einen durchschnittlichen Porendurchmesser von 10 $\mu$m oder weniger aufweisen; und
wobei der Film eine dielektrische Konstante, wie bei 60 GHz gemessen, von 2,0 oder weniger aufweist, wobei alle vorstehend definierten Parameter gemäß den Verfahren bestimmt werden, die in dem experimentellen Abschnitt dieser Patentschrift offenbart werden.

2. Film nach Anspruch 1, wobei die Hautschicht eine Dicke aufweist, die weniger als 10 % einer Gesamtdicke des Films beträgt.

3. Film nach Anspruch 2, wobei die Dicke der Hautschicht gleich oder weniger als 5 % der Gesamtdicke des Films beträgt.

4. Film nach einem der Ansprüche 1 bis 3, wobei die Hautschicht auf beiden der Oberflächen der Basismaterialschicht ausgebildet ist.

5. Film nach einem der Ansprüche 1 bis 4, wobei die Hautschicht flüssigkeitsundurchlässig ist.

6. Film nach einem der Ansprüche 1 bis 5, wobei die Basismaterialschicht eine Porosität, wie gemäß den Verfahren, die in dem experimentellen Abschnitt offenbart werden, bestimmt, von 95 % oder weniger aufweist.

7. Film nach einem der Ansprüche 1 bis 6, wobei die Poren in der Basismaterialschicht eine Porendurchmesserverteilung mit einer vollen Breite bei halbem Maximum, wie gemäß den Verfahren, die in dem experimentellen Abschnitt offenbart werden, bestimmt, von 10 $\mu$m oder weniger aufweist.

8. Film nach einem der Ansprüche 1 bis 7, wobei das Polymer oder ein Vorläufer des Polymers in einem organischen Lösungsmittel löslich ist, vorzugsweise wobei das organische Lösungsmittel N-Methylpyrrolidon ist.

9. Film nach einem der Ansprüche 1 bis 8, wobei das Polymer aus der Gruppe ausgewählt ist, bestehend aus Polyimid, Polyetherimid, fluoriertem Polyimid und Polycarbonat.

10. Film nach einem der Ansprüche 1 bis 9, der eine Dicke, wie gemäß den Verfahren, die in dem experimentellen Abschnitt offenbart werden, bestimmt, von 50 $\mu$m bis 500 $\mu$m aufweist.

11. Film nach einem der Ansprüche 1 bis 10, der eine poröse Struktur aufweist, die als Struktur mit unabhängigen Zellen ausgebildet ist.

12. Platine für eine Millimeter-Wellenantenne, umfassend den Film nach einem der Ansprüche 1 bis 11.

## Revendications

1. Film polymère poreux à faible constante diélectrique comportant :

une couche de matériau de base réalisée à partir d'un matériau polymère et formée avec des pores fins dispersés dans celle-ci ; et
une couche de peau sensiblement lisse réalisée à partir du même matériau polymère que celui de la couche de matériau de base mais n'ayant aucun pore et formée sur au moins l'une des surfaces de la couche de matériau de base ;
dans lequel la couche de peau a une épaisseur de 1 à 5 $\mu$m ; dans lequel la couche de matériau de base a une porosité de 60 % ou plus ;
dans lequel les pores de la couche de matériau de base ont un diamètre moyen des pores de 10 $\mu$m ou moins ; et
dans lequel le film a une constante diélectrique telle qu'elle est mesurée à 60 GHz de 2,0 ou moins, tous les paramètres définis ci-dessus étant déterminés en fonction des procédés divulgués dans la section expérimentale de cette spécification.

**2.** Film selon la revendication 1, dans lequel la couche de peau a une épaisseur qui est inférieure à 10 % d'une épaisseur totale du film.

**3.** Film selon la revendication 2, dans lequel l'épaisseur de la couche de peau est égale ou inférieure à 5 % de l'épaisseur totale du film.

**4.** Film selon l'une quelconque des revendications 1 à 3, dans lequel la couche de peau est formée sur les deux surfaces de la couche de matériau de base.

**5.** Film selon l'une quelconque des revendications 1 à 4, dans lequel la couche de peau est imperméable aux liquides.

**6.** Film selon l'une quelconque des revendications 1 à 5, dans lequel la couche de matériau de base a une porosité, déterminée en fonction du procédé divulgué dans la section expérimentale, de 95 % ou moins.

**7.** Film selon l'une quelconque des revendications 1 à 6, dans lequel les pores dans la couche de matériau de base ont une distribution de diamètres des pores avec une pleine largeur au niveau de la moitié du maximum, déterminée en fonction du procédé divulgué dans la section expérimentale, de 10 $\mu$m ou moins.

**8.** Film selon l'une quelconque des revendications 1 à 7, dans lequel le polymère, ou un précurseur du polymère, est soluble dans un solvant organique, de préférence le solvant organique est de la N-méthylpyrrolidone.

**9.** Film selon l'une quelconque des revendications 1 à 8, dans lequel le polymère est sélectionné dans le groupe constitué par du polyimide, de la polyéthérimide, du polyimide fluoré, et du polycarbonate.

**10.** Film selon l'une quelconque des revendications 1 à 9, qui a une épaisseur, déterminée en fonction du procédé divulgué dans la section expérimentale, de 50 $\mu$m à 500 $\mu$m.

**11.** Film selon l'une quelconque des revendications 1 à 10, qui a une structure poreuse formée sous la forme d'une structure de cellules indépendantes.

**12.** Carte pour une antenne à ondes millimétriques comportant le film selon l'une quelconque des revendications 1 à 11.

[FIG. 1a]

## FIG.1a

[FIG. 1b]

## FIG.1b

[FIG. 2a]

## FIG.2a

[FIG. 2b]

## FIG.2b

19

[FIG. 3a]

## FIG.3a

5.00kV 8.9mm x500 SE      100um

[FIG. 3b]

## FIG.3b

SEI   5kV    WD14mm    SS30     x500    50 μm
Sample                     0000    22 Oct 2015

[FIG. 4a]

## FIG.4a

5.00kV 9.1mm x500 SE                                    100um

[FIG. 4b]

## FIG.4b

SEI    5kV    WD14mm    SS30        x500    50 $\mu$ m

Sample                                    0000        22 Sep 2015

[FIG. 5]

## FIG.5

[FIG. 6]

## FIG.6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H09100363 A
- JP 2012101438 A
- JP 2003201362 A

- JP 2001081225 A
- JP 2002146085 A